(19) Europäisches Patentamt
European Patent Office
Office européen des brevets

(11) EP 3 826 076 A1

(12) EUROPEAN PATENT APPLICATION

(43) Date of publication:
**26.05.2021 Bulletin 2021/21**

(51) Int Cl.:
***H01L 31/055*** *(2014.01)*

(21) Application number: **20209691.3**

(22) Date of filing: **25.11.2020**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
**KH MA MD TN**

(30) Priority: **25.11.2019 IT 201900022068**

(71) Applicant: **Università di Pisa**
**56126 Pisa (IT)**

(72) Inventors:
- **PUCCI, Andrea**
  **56122 PISA (IT)**
- **RUGGERI, Giacomo**
  **56124 PISA (IT)**
- **MINEI, Pierpaolo**
  **56124 PISA (IT)**
- **IASILLI, Giuseppe**
  **56010 SAN GIULIANO TERME (IT)**

(74) Representative: **Biggi, Cristina**
**Bugnion S.p.A.**
**Viale Lancetti 17**
**20158 Milano (IT)**

# (54) LUMINESCENT SOLAR CONCENTRATORS FROM FILM-FORMING AQUEOUS POLYMER DISPERSIONS

(57) The present invention relates to a luminescent solar concentrator (LSC) comprising an aqueous polymer dispersion comprising at least one fluorescent compound dispersed in said aqueous polymer dispersion. Preferably, said at least one fluorescent compound is a coumarin derivative selected from 2-[7-diethylamino)-2-oxo-2H-1-benzopyran-3-yl]-1,3-dimethyl-1H-benzimidazolium chloride (Basic Yellow 40, CAS no. 29556-33-0), Acid Yellow 250 (CAS no. 70267-73-1), Disperse Yellow 184 (CAS no. 67297-27-2), a compound having the formula (I) (Disperse Red 277, CAS no. 70294-19-8),

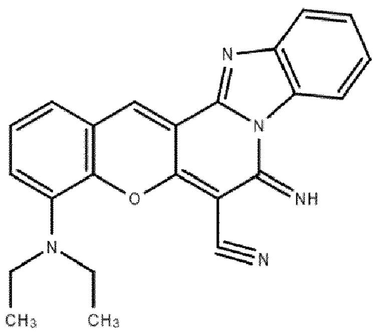

(I)

and a combination thereof.

The subject matter of the present invention also relates to a luminescent solar concentrator comprising a substrate partially or entirely coated with a polymeric film obtained from said aqueous polymer dispersion. The present invention further relates to a device for exploiting solar energy comprising at least one luminescent solar concentrator comprising a substrate as described above and at least one cell selected from photovoltaic or photoelectrochemical cells, as well as the use of said device as an element for the construction and/or decoration of an architectural structure.

EP 3 826 076 A1

## Description

### FIELD OF THE INVENTION

The present invention relates to a luminescent solar concentrator comprising an aqueous polymer dispersion comprising at least one fluorescent compound dispersed therein. The present invention also relates to a luminescent solar concentrator comprising a substrate coated with said dispersion and a device for exploiting solar energy comprising at least one luminescent solar concentrator.

### PRIOR ART

In the last decades, hand in hand with the increasing technological development of renewable energies and with growing world awareness on the issue of pollution and sustainable development, the government bodies of the most industrialised countries have begun to incentivise the dissemination of photovoltaic energy in urban contexts, in particular by favouring the construction of new so-called "net zero-energy buildings" (NZEBs), i.e. buildings that balance their energy consumption by guaranteeing a yearly base production of renewable energy.

At present, the construction of such buildings is technically cost-effective solely in the case of individual homes and/or small buildings thanks to the installation of photovoltaic cells on their roof. However, considering that in order to be able to be considered an NZEB, about 7 $m^2KW^{-1}$ of peak power are necessary, the use of the photovoltaic cells installed only on the roof proves not to be cost-effective in the case of larger buildings, in which most of the exterior surface is distributed over the lateral faces and is thus, in fact, unusable for the installation of classic photovoltaic cells.

One of the most modern systems capable of favouring the use of photovoltaic energy also in buildings of a large size (such as for example skyscrapers), i.e. in environments with a high population density, relates to the use of luminescent solar concentrators (LSCs). Typical luminescent solar concentrators comprise a flat substrate made of a material that is transparent for the radiation of interest (i.e. solar radiation) and contains within it fluorophores with a high quantum yield capable of absorbing the incident luminous radiation and of emitting fluorescence concentrated on the edges of the substrate itself thanks to the so-called waveguide principle. The solar radiation collected on the base surface of the substrate is in fact conveyed onto its lateral surfaces, which are smaller, thus obtaining a more intense, i.e. more concentrated radiation. This mechanism can therefore be effectively employed inside devices for exploiting solar energy comprising LSCs and photovoltaic cells, which, generally placed at the edges of the LSCs, convert light energy into electricity.

Moreover, one of the largest advantages of devices comprising LSCs is tied to the fact that, compared to traditional photovoltaic cells on their own, they are less sensitive to the angle of orientation of the incident radiation and less penalised by power fluctuations deriving from shadows (for example clouds), thus making them ideal for use on and integration into the lateral surfaces of large buildings in urban contexts, in particular in urban contexts with a medium or high population density.

Therefore, it is of increasing interest to design high-efficiency, low-cost LSCs in order to be able maximise the dissemination of photovoltaic energy in said urban contexts.

In recent years, technological research in this sector has mainly centred on three fundamental aspects: 1) the preparation of fluorophores that are increasingly efficient and photostable, i.e. capable of absorbing most of the incident radiation and re-emitting it not only with the highest quantum yield possible, but also in a spectral window that is more comparable to that of the maximum light energy-electricity conversion of the selected photovoltaic cell; 2) the development of technologies aimed at reducing the losses of optical efficiency by providing structures that maximise the capture of the radiation emitted by the fluorophore inside the device; and 3) the preparation and selection of amorphous, photostable transparent materials capable of effectively dispersing the selected fluorophores within them.

The latter aspect in particular is still today the one posing the largest problems.

At the present state of the art, LSCs are generally prepared from a substrate of polymeric material, generally poly(methyl methacrylate) (PMMA), functionalised by adding a fluorophore during the polymerisation reaction - in bulk or in a solution - or during the process of extrusion and/or thermoforming of the substrate. Alternatively, another method usually used for the production of LSCs envisages impregnating a substrate of polymeric material (already preformed) with a solution of a fluorophore in organic solvent (generally chlorinated).

However, all of the solutions proposed above pose numerous disadvantages tied to the fact that, in the first two cases, the chemical reactions that occur during a polymerisation reaction and the high temperature conditions usually employed both during said reactions and in subsequent processing can lead to degradation of the fluorophore incorporated within the polymerised material, whereas in the last case the use of organic solvents can be potentially polluting for the environment as well as toxic for human health.

Patent application WO2015/159221 proposes a further solution with the aim of solving the above-mentioned problems. This document in fact describes a luminescent solar concentrator comprising a substrate made of polymeric

material and subjected to impregnation with an aqueous emulsion or microemulsion comprising micelles containing an organic solvent immiscible with water (for example toluene) and a fluorophore that is soluble and stable in that organic solvent.

A. Renny et al. ("Luminescent Solar Concentrator Paintings: Connecting Art and Energy", J. Chem. Educ. 2018, 95, 1161-1166), on the other hand, described luminescent solar concentrators obtained from a sheet of PMMA coated with a paint comprising a solution of a poly(butyl methacrylate-co-methyl methacrylate) polymeric resin combined with a fluorescent dye dissolved into acetone.

In these cases as well, however, the proposed solutions pose technological disadvantages since they do not allow eliminating the use of an organic solvent, which is instead essential for the solubilisation of the fluorophore.

In the sector there thus remains a need to be able to produce and market luminescent solar concentrators that do not require the use of organic solvents.

The present invention solves the above-described problems of the prior art by providing a luminescent solar concentrator that does not require the use of organic solvents, that is, one comprising an aqueous polymer dispersion in which a water-soluble fluorescent compound is dispersed, and which, once deposited on a substrate, forms a homogeneous polymeric film adherent thereto. The present invention further provides a device for exploiting solar energy comprising at least one luminescent solar concentrator comprising said substrate, i.e. a device for exploiting solar energy whose preparation does not require the use of organic solvents.

## SUMMARY OF THE INVENTION

The subject matter of the present invention relates to a luminescent solar concentrator (LSC) comprising an aqueous polymer dispersion comprising at least one fluorescent compound dispersed in said aqueous polymer dispersion, said at least one fluorescent compound being water soluble. Preferably, said at least one fluorescent compound is present in an amount comprised between 0.2 and 10% by weight, preferably between 0.5 and 7% by weight, more preferably between 1 and 5%, even more preferably between 2 and 5%, even more preferably between 0.2 and 2% by weight relative to the total weight of the luminescent solar concentrator. In one embodiment, said at least one fluorescent compound is a coumarin derivative selected from 2-[7-diethylamino)-2-oxo-2H-1-benzopyran-3-yl]-1,3-dimethyl-1 H-benzimidazolium chloride (Basic Yellow 40, CAS no. 29556-33-0), Acid Yellow 250 (CAS no. 70267-73-1), Disperse Yellow 184 (CAS no. 67297-27-2), a compound having the formula (I) (Disperse Red 277, CAS no. 70294-19-8),

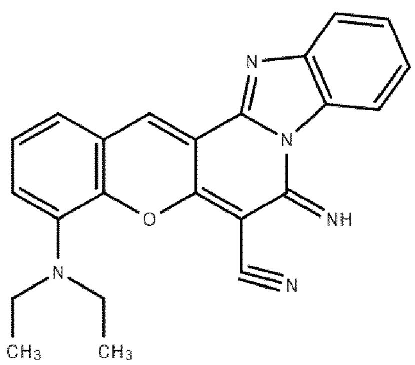

(I)

and a combination thereof.

Preferably, said aqueous polymer dispersion comprises at least one polymer selected in the group consisting of an acrylic-styrene acid ester (co)polymer, an acrylic-methacrylic acid ester (co)polymer, a polyester-based aliphatic polyurethane, and a combination thereof.

The subject matter of the present invention also relates to a luminescent solar concentrator comprising a substrate partially or entirely coated with a polymeric film obtained from said aqueous polymer dispersion, said substrate preferably being made of a transparent or translucent material, preferably a vitreous and/or polymeric material. The subject matter of the present invention further relates to a device for exploiting solar energy comprising at least one luminescent solar concentrator comprising said substrate and at least one cell selected from photovoltaic or photoelectrochemical cells as well as the use of said device as an element for the construction and/or decoration of an architectural structure, said element preferably being selected from a window, a French door, a display window, a terrace, a balcony, a parapet, a motorway sound-absorbing panel and a vehicle roof; said architectural structure being preferably selected from a building, a greenhouse and an infrastructure.

## BRIEF DESCRIPTION OF THE FIGURES

Figure 1 shows an operating diagram of a device for exploiting solar energy according to one embodiment of the present invention.

Figure 2 shows the device for exploiting solar energy according to a preferred embodiment of the invention, used as a window installed in a residential building.

Figure 3 shows a comparison, under irradiation with visible light, between the sample LSC103 comprising a glass substrate having a base surface exposed to radiation that is entirely coated with a fluorescent polymeric film comprising ®Polidisp 7788 and 1% by weight of Basic Yellow 40 as described in Example 1, and a sample consisting of a similar glass substrate, but without the deposition of said fluorescent polymeric film.

Figure 4 shows a comparison, under irradiation with UV light at 366 nm, between the sample LSC103 comprising a glass substrate entirely coated with a fluorescent polymeric film comprising ®Polidisp 7788 and 1% by weight of Basic Yellow 40 as described in Example 1, and a sample consisting of a similar glass substrate, but without the deposition of said fluorescent polymeric film.

Figure 5 shows a graph representing the current (A) and power (W) curves as a function of voltage for a photovoltaic (PV) cell alone (broken lines) and for the LSC+PV cell device (continuous lines) for the sample LSC103 as obtained from Example 1.

Figure 6 shows a graph representing the current (A) and power (W) curves as a function of voltage for a photovoltaic (PV) cell alone (broken lines) and for the LSC+PV cell device (continuous lines) for the sample LSC305 as obtained from Example 3.

## DETAILED DESCRIPTION OF THE INVENTION

For the purposes of the present invention, the term "polymeric material" or "plastic material" means a wide range of high molecular weight, synthetic or semi-synthetic organic polymeric compounds which are malleable and can therefore be moulded into solid objects. Said organic polymeric compounds can be pure (co)polymers or (co)polymers comprising other substances, such as, for example, organic and/or inorganic additives, aimed at improving their properties and reducing costs.

For the purposes of the present invention, the term "(co)polymer" is used to indicate both polymers, also called homopolymers, i.e. macromolecules whose polymeric chain contains repetitive units obtained from the union of monomers of only one type, and copolymers, i.e. macromolecules whose polymeric chain contains repetitive units obtained from the union of monomers of two or more different types.

For the purposes of the present invention the term "transparent" refers to the physical property of transparency, i.e. the property which allows light having frequency values comprised within the frequencies of solar radiation (thus also visible light) to pass through a material. In particular, for the purposes of the present invention, a material is defined "transparent" if it transmits light having frequency values comprised within the frequencies of solar radiation and enables a clear observation of an object through it.

The term "translucent" refers to the physical property of translucency, which allows light having frequency values comprised within the frequencies of solar radiation to pass through a material in a diffused manner.

In particular, for the purposes of the present invention, a material is defined as "translucent" if it transmits light having frequency values comprised within the frequencies of solar radiation by diffusing it but is not transparent, i.e. if said material does not enable a clear observation of an object observed through it.

The term "opaque" refers to the physical property of opacity, which does not allow light having frequency values comprised within the frequencies of solar radiation to pass through a material.

In particular, for the purposes of the present invention, a material is defined as "opaque" if it does not transmit light having frequency values comprised within the frequencies of solar radiation, i.e. if it is impenetrable to light having frequency values comprised within the frequencies of solar radiation and thus totally prevents the observation of an object through it. For the purposes of the present invention, the term "sunlight" or "solar radiation" or "solar energy" means the radiant energy emitted in interplanetary space by the sun, which comprises electromagnetic radiation at various wavelengths. In particular, about 50% of solar radiation is emitted in the infrared region (NIR, near the visible region and comprised between about 750 nm and about 1500 nm), about 5% in the ultraviolet region and the rest in the visible region.

The term "fluorescent compound" or "fluorophore" indicates molecules which, after having absorbed photons of a certain wavelength, exhibit the phenomenon of fluorescence, i.e. the phenomenon whereby a molecule struck by luminous radiation at a certain wavelength (excitation frequency) emits another with a larger wavelength (emission frequency).

For the purposes of the present invention, the terms "photovoltaic cell" or "solar cell" are used as interchangeable synonyms indicating a solid-state device (semiconductor) that converts the energy of incident sunlight into electricity by means of the photovoltaic effect.

For the purposes of the present invention, the term "photoelectrochemical cell" means a solar cell that derives electrical energy from light having frequency values comprised within the frequencies of solar radiation (including visible radiation). A photoelectrochemical cell consists of one or more electrodes; at least one of these electrodes is a photoelectrode (photoanode or photocathode), i.e. an electrode consisting of a material capable of developing an electric current following the absorption of light energy. The operation of a photoelectrochemical cell is similar to that of an electrochemical cell, with the difference that the redox reaction that takes place at the photoelectrode exploits light energy for the advancement thereof.

The subject matter of the present invention relates to a luminescent solar concentrator (LSC) comprising an aqueous polymer dispersion comprising at least one fluorescent compound dispersed in said aqueous polymer dispersion, said at least one fluorescent compound being water soluble. According to one embodiment of the invention, said at least one fluorescent compound is present in an amount comprised between 0.2 and 10% by weight, preferably between 0.5 and 7% by weight, more preferably between the 1 and 5%, even more preferably between 2 and 5%, even more preferably between 0.2 and 2% by weight relative to the total weight of the luminescent solar concentrator.

According to one embodiment of the invention, said at least one water-soluble fluorescent compound is a coumarin-derived fluorescent compound.

Preferably, said at least one coumarin-derived fluorescent compound is selected from: 2-[7-diethylamino)-2-oxo-2H-1-benzopyran-3-yl]-1,3-dimethyl-1 H-benzimidazolium chloride (Basic Yellow 40, CAS no. 29556-33-0), Acid Yellow 250 (CAS no. 70267-73-1), Disperse Yellow 184 (CAS no. 67297-27-2), a compound having the formula (I) (Disperse Red 277, CAS no. 70294-19-8),

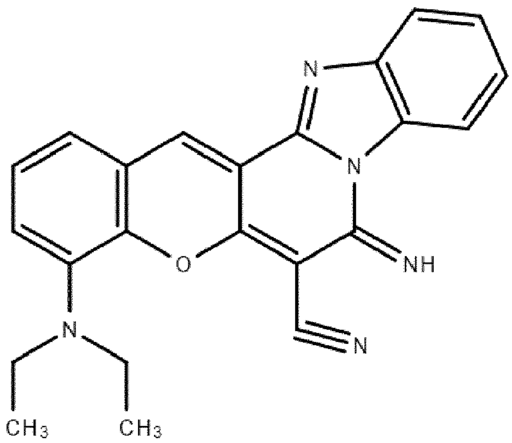

(I)

and a combination thereof.

According to a preferred embodiment of the invention, said at least one coumarin-derived fluorescent compound is 2-[7-diethylamino)-2-oxo-2H-1-benzopyran-3-yl]-1,3-dimethyl-1 H-benzimidazolium chloride (Basic Yellow 40, CAS no. 29556-33-0).

According to one embodiment of the invention, said aqueous polymer dispersion is a film-forming aqueous polymer dispersion. Preferably, said aqueous polymer dispersion comprises at least one polymer selected in the group consisting of an acrylic-styrene acid ester (co)polymer, an acrylic-methacrylic acid ester (co)polymer, a polyester-based aliphatic polyurethane, a polyether-based aliphatic polyurethane, and a combination thereof.

According to one embodiment of the invention, the aqueous polymer dispersion is an aqueous dispersion comprising an acrylic-styrene acid ester (co)polymer known by the trade name ®Polidisp 7602.

According to a further embodiment of the invention, the aqueous polymer dispersion is an aqueous dispersion comprising an acrylic-methacrylic acid ester (co)polymer known by the trade name ®Polidisp 7788.

According to a further embodiment of the invention, the aqueous polymer dispersion is an aqueous dispersion comprising a polyester-based aliphatic polyurethane known by the trade name ®Tecfin P40.

According to a particularly preferred embodiment, the aqueous dispersion according to the present invention is selected from an aqueous dispersion comprising an acrylic-styrene acid ester (co)polymer known by the trade name ®Polidisp 7602, an aqueous dispersion comprising an acrylic-methacrylic acid ester (co)polymer known by the trade

name ®Polidisp 7788, an aqueous dispersion comprising a polyester-based aliphatic polyurethane known by the trade name ®Tecfin P40 and a combination thereof.

According to one embodiment of the invention, said aqueous polymer dispersion comprises said at least one polymer in an amount comprised between 20 and 60% by weight, preferably between 30 and 55% by weight relative to the total weight of the aqueous polymer dispersion. According to one embodiment, the luminescent solar concentrator (LSC) of the present invention is obtained by mixing an aqueous polymer dispersion with an aqueous solution of at least one fluorescent compound as previously described until obtaining a final aqueous polymer dispersion comprising said aqueous polymer dispersion and said at least one fluorescent compound dispersed in said aqueous polymer dispersion. Preferably, said at least one fluorescent compound is homogeneously dispersed in said aqueous polymer dispersion.

Without wishing to be bound to a specific theory, the Applicant has found that said fluorescent compound is not only water soluble but, once mixed with said aqueous polymer dispersion, it shows to be perfectly compatible therewith also when used in a large amount (up to 10% by weight relative to the total weight of the luminescent solar concentrator), i.e. it is homogeneously dispersed therein, thus forming a final aqueous polymer dispersion (i.e. the luminescent solar concentrator according to the present invention) which is stable over time.

The subject matter of the present invention also relates to a luminescent solar concentrator comprising a substrate partially or entirely coated with a polymeric film obtained from the aqueous polymer dispersion comprising at least one fluorescent compound as previously described, said polymeric film comprising said at least one fluorescent compound uniformly distributed therein.

In other words, the solar concentrator of the present invention can be in liquid form, i.e. a luminescent solar concentrator comprising an aqueous polymer dispersion comprising at least one fluorescent compound dispersed therein, or in solid form, i.e. a luminescent solar concentrator comprising a substrate partially or entirely coated with a polymeric film obtained from said aqueous polymer dispersion, said polymeric film comprising said at least one fluorescent compound uniformly distributed therein.

For the purposes of the present invention, said aqueous polymer dispersion can thus also be defined as a film-forming aqueous polymer dispersion, i.e. an aqueous polymer dispersion which, once deposited on a surface and once the aqueous component has evaporated, forms a polymeric film adherent to said surface, said polymeric film comprising, uniformly distributed therein, the at least one fluorescent compound initially present within said aqueous polymer dispersion.

For the purposes of the present invention, said polymeric film comprising said at least one fluorescent compound, can be defined as a "fluorescent polymeric film".

According to a particularly preferred embodiment, said at least one fluorescent compound is present in said polymeric film that partially or entirely coats said substrate in an amount comprised between 0.5 and 7%, preferably between 0.2 and 2%, relative to the total weight of the polymeric film.

Said substrate partially or entirely coated with said polymeric film is preferably obtained by means of a technique for depositing the aqueous polymer dispersion on a part of or on the entire substrate, said technique being selected from: "spray coating", "flow coating", "dip coating", "solvent casting", "spin coating", "Meyer bar coating", "gravure coating", "knife coating", "kiss coating", "die coating", and a combination thereof. According to one embodiment of the invention, said polymeric film has a homogeneous thickness, preferably comprised between 25 and 300 $\mu$m, more preferably between 40 and 100 $\mu$m.

Without wishing to be bound to a specific theory, the Applicant has found that said polymeric film, once formed on said substrate, not only has a homogeneous thickness but is also uniformly distributed and adherent to the surface of the substrate itself. Furthermore, the distribution of the fluorescent compound within said polymeric film is likewise homogeneous and uniform.

According to a preferred embodiment, once the deposition of the aqueous polymer dispersion has been completed, the substrate is subjected to a heating cycle, preferably at a temperature comprised between 20 and 80 °C, more preferably comprised between 40 and 60 °C. Preferably, during said heating cycle said temperature is maintained for a duration comprised between 2 and 24 hours, preferably from 3 to 20 hours. Advantageously, this further step comprising said heating cycle enables the evaporation of any residual water deriving from the deposition of the aqueous polymer dispersion on the substrate, thus facilitating the formation of a polymeric film with the desired characteristics of homogeneity and thickness described above.

According to a particularly preferred embodiment, said polymeric film is transparent or translucent for solar radiation. Said polymeric film is preferably characterised by having a refraction index comprised between 1.4 and 1.6.

According to a particularly preferred embodiment of the invention, said substrate comprises at least one base surface and at least one lateral surface, said at least one lateral surface having a surface area that is smaller than the surface area of the at least one base surface. Said substrate is preferably made of a material that is transparent or translucent for solar radiation.

Said transparent or translucent material is preferably a material selected from vitreous and/or polymeric materials. More preferably, said transparent or translucent material is selected in the group consisting of: glass, polymethylmethacrylate (PMMA), polycarbonate (PC), copolymers of cyclic olefins and epoxy resins.

Said substrate preferably has a geometric shape such as to comprise at least one base surface and at least one lateral surface. More preferably, said substrate has the geometric shape of a parallelepiped, even more preferably a rectangular parallelepiped.

According to a preferred embodiment of the invention, said substrate is a transparent glass substrate having the shape of a rectangular parallelepiped.

The characteristics of transparency or translucency of the polymeric film according to this particularly preferred embodiment of the invention prove to be particularly advantageous, since the luminescent solar concentrator obtained following the formation of said polymeric film on a transparent or translucent substrate is not opaque, but rather maintains a desired degree of residual transparency or translucency even in the event that said substrate is entirely coated with said polymeric film.

Another advantage of the luminescent solar concentrator comprising a substrate partially or entirely coated with a polymeric film obtained from the deposition, on said substrate, of the aqueous polymer dispersion according to the present invention, resides in the fact that, as said polymeric film comprises at least one fluorescent compound (initially present within said aqueous polymer dispersion), the action of the luminescent solar concentrator is actually performed by said polymeric film. The Applicant has therefore found that, in the event that said polymeric film deposited on said substrate becomes deteriorated or loses its effectiveness, for example as a result of external agents such as adverse climate conditions, air pollution or excessively aggressive cleaning operations on the substrate, the luminescent solar concentrator of the present invention (comprising said substrate partially or entirely coated with said polymeric film) can be easily regenerated by removing, if necessary, the deteriorated polymeric film and subsequently depositing a new polymeric film.

The subject matter of the present invention also relates to a device for exploiting solar energy comprising at least one luminescent solar concentrator as previously described and at least one cell selected from photovoltaic or photoelectrochemical cells.

As schematically represented in Figure 1, according to a particularly preferred embodiment, the device for exploiting solar energy according to the present invention comprises (i) at least one luminescent solar concentrator comprising a substrate partially or entirely coated with a polymeric film comprising at least one fluorescent compound uniformly distributed therein, said polymeric film being obtained from the deposition of the aqueous polymer dispersion as previously described, and (ii) at least one cell selected from photovoltaic or photoelectrochemical cells, said at least one cell being connected with said substrate and being positioned on at least one lateral surface of said substrate.

According to this particularly preferred embodiment of the invention, said device for exploiting solar energy is characterised by having an optical efficiency value $\eta$% comprised between 5 and 10%, preferably between 6 and 10%.

For the purposes of the present invention, the optical efficiency $\eta$% is obtained from the ratio between the concentration factor (C) and the geometric factor (G) according to the equations (1) and (2), following the connection of said substrate with said at least one cell selected from photovoltaic (PV) or photoelectrochemical (PE) cells:

(1) $C=I_{LSC+(PVor\ PE)}/I_{(PV\ or\ PE)}$
(2) (base surface area)/(lateral surface area)

wherein the concentration factor (C) is given by the ratio between the parameters $I_{LSC+(PV\ or\ PE)}$ and $I_{(PV\ or\ PE)}$, which represent, respectively, the short circuit intensities of the device in the presence and in the absence of the luminescent solar concentrator (LSC), as obtained from the maximum recorded current values, whilst the geometric factor (G) is given by the ratio between the base surface and the lateral surface of the substrate.

The device for exploiting solar energy according to this particularly preferred embodiment of the invention comprising at least one luminescent solar concentrator comprising a substrate partially or entirely coated with a polymeric film obtained from the deposition, on said substrate, of the aqueous polymer dispersion as previously described, has the advantage that, as said polymeric film comprises at least one fluorescent compound (initially present within said aqueous polymer dispersion), the action of the luminescent solar concentrator is actually performed by said polymeric film. The Applicant has therefore found that, in the event that said polymeric film deposited on said substrate becomes deteriorated or loses its effectiveness, for example as a result of external agents such as adverse climate conditions, air pollution or excessively aggressive cleaning operations on the substrate, the device for exploiting solar energy of the present invention can be easily regenerated by removing, if necessary, the deteriorated polymeric film and subsequently depositing a new polymeric film without having to change the at least one cell selected from photovoltaic or photoelectrochemical cells, thus resulting in considerable savings as regards the costs tied both to the disposal and production of photovoltaic or photoelectrochemical cells and the maintenance of the device itself. The ease of regenerating the luminescent solar concentrator comprised within the device for exploiting solar energy according to the present invention thus enables the life of the device itself to be lengthened through a simple operation of re-depositing the polymeric film (comprising at least one fluorescent compound), without any need to change the at least one photovoltaic or photoelectrochemical cell.

Finally, the subject matter of the present invention also relates to the use of the device for exploiting solar energy as previously described as an element for the construction and/or decoration of an architectural structure. According to one embodiment, said element is selected from a window, a French door, a display window, a terrace, a balcony, a parapet, a motorway sound-absorbing panel and a vehicle roof.

Said architectural structure is preferably selected from a building, a greenhouse and an infrastructure.

In a preferred embodiment of the invention, as schematically illustrated in Figure 2, the device for exploiting solar energy is used as a window installed in a residential building. For the purposes of the present invention, said window is definable as a "photovoltaic window" or "photoelectrochemical window".

According to this embodiment said device used as a window preferably comprises the at least one photovoltaic or photoelectrochemical cell inside the frame of said window.

## EXAMPLES

EXAMPLE 1 - Preparation of a solar concentrator comprising Basic Yellow 40

A solution (called "stock solution") was initially prepared by dissolving the fluorescent compound 2-[7-diethylamino)-2-oxo-2H-1-benzopyran-3-yl]-1,3-dimethyl-1H-benzimidazolium chloride (Basic Yellow 40, CAS no. 29556-33-0) in deionised water until obtaining a homogeneous solution with a fluorescent compound concentration equal to 3 mg/mL. The fluorescent compound showed to be completely water soluble. Subsequently, 0.6 g of an acrylic-based aqueous polymer dispersion (comprising acrylic-methacrylic acid ester (co)polymer, known by the trade name ®Polidisp 7788, containing 50% of solid fraction relative to the total weight of the dispersion) was introduced into a reaction container and deionised water was added thereto - until a final volume of 1.5 mL - along with the previously prepared stock solution of the fluorescent compound until obtaining a final aqueous polymer dispersion comprising the fluorescent compound at a concentration equal to 0.3% (sample LSC101), 0.6% (sample LSC102), 1% (sample LSC103) and 1.5% (sample LSC104) by weight relative to the total weight of said aqueous polymer dispersion. The dispersion thus obtained was kept under magnetic stirring in order to obtain perfect homogeneity.

A glass substrate of high optical purity (Edmund Optics Ltd BOROFLOAT window 50x50 TS), having nominal dimensions of 50x50x3 mm, was cleaned on the surface by means of a first washing with a solution of HCl at 6% v/v and subsequent washing with deionised water followed by common washing solvents such as acetone, ethanol, isopropanol and diethyl ether. The substrate was then dried in an oven overnight at a temperature of 100°C and allowed to cool down slowly to room temperature. The substrate was then placed on a perfectly flat, levelled system, and the surface thereof was entirely and uniformly covered, using a Pasteur pipette, with the previously obtained aqueous polymer dispersion containing the fluorescent compound. Subsequently, the system was covered with a watch glass so as to permit an extremely gradual evaporation of the water and, therefore, to favour the formation of a highly homogeneous fluorescent polymeric film devoid of surface defects. At the end of the evaporation, with the film completely dry, the next step was to characterise and evaluate the optical performance of the luminescent solar concentrators obtained, comprising different amounts of the Fluorescent compound Basic Yellow 40, as described in the Examples below.

EXAMPLE 2

The synthesis described in Example 1 was repeated by exactly reproducing all the steps but using, in the place of an acrylic-based aqueous polymer dispersion (comprising acrylic-methacrylic acid ester (co)polymer, known by the trade name ®Polidisp 7788, containing 50% of solid fraction relative to the total weight of the dispersion), 0.6 g of an acrylic-styrene-based aqueous polymer dispersion (comprising acrylic-styrene acid ester (co)polymer, known by the trade name ®Polidisp 7602). In this case, the stock solution of the fluorescent compound was added until obtaining a final aqueous polymer dispersion comprising the fluorescent compound at a concentration equal to 0.5% (sample LSC201), 1% (sample LSC202), 1.5% (sample LSC203) and 2% (sample LSC204) by weight relative to the total weight of said aqueous polymer dispersion.

In this case as well, at the end of the evaporation, with the film completely dry, the next step was to characterise and evaluate the optical performance of the luminescent solar concentrators obtained, comprising different amounts of the Fluorescent compound Basic Yellow 40, as described in the Examples below.

EXAMPLE 3

The synthesis described in Example 1 was repeated by exactly reproducing all the steps but using, in the place of an acrylic-based aqueous polymer dispersion (comprising acrylic-methacrylic acid ester (co)polymer, known by the trade name ®Polidisp 7788, containing 50% of solid fraction relative to the total weight of the dispersion), 1 g of a

polyurethane-based aqueous polymer dispersion (comprising polyester-based aliphatic polyurethane, known by the trade name ®Tecfin 40). In this case, the stock solution of the fluorescent compound was added until obtaining a final aqueous polymer dispersion comprising the fluorescent compound at a concentration equal to 0.3% (sample LSC301), 0.5% (sample LSC302), 0.6% (sample LSC303), 1% (sample LSC304) and 2% (sample LSC305) by weight relative to the total weight of said aqueous polymer dispersion.

In this case as well, at the end of the evaporation, with the film completely dry, the next step was to characterise and evaluate the luminescent solar concentrators obtained, comprising different amounts of the Fluorescent compound Basic Yellow 40, as described in the Examples below.

EXAMPLE 4 - Preparation of a solar concentrator comprising Disperse Red 277

The synthesis described in Example 1 was repeated by exactly reproducing all the steps but using, in the place of the fluorescent compound 2-[7-diethylamino)-2-oxo-2H-1-benzopyran-3-yl]-1,3-dimethyl-1H-benzimidazolium chloride (Basic Yellow 40, CAS no. 29556-33-0), the fluorescent compound having the formula (I) (Disperse Red 277, CAS no. 70294-19-8),

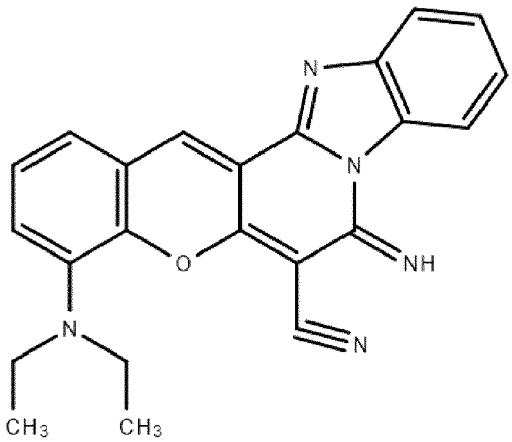

(I)

and, in the place of an acrylic-based aqueous polymer dispersion (comprising acrylic-methacrylic acid ester (co)polymer, known by the trade name ®Polidisp 7788, containing 50% of solid fraction relative to the total weight of the dispersion), 0.6 g of an acrylic-styrene-based aqueous polymer dispersion (comprising acrylic-styrene acid ester (co)polymer, known by the trade name ®Polidisp 7602).

In this case the stock solution of the fluorescent compound was added until obtaining a final aqueous polymer dispersion comprising the fluorescent compound at a concentration equal to 0.5% (sample LSC401), 1% (sample LSC402), 1.5% (sample LSC403) and 2% (sample LSC404) by weight relative to the total weight of said aqueous polymer dispersion. In this case as well, at the end of the evaporation, with the film completely dry, the next step was to characterise and evaluate the luminescent solar concentrators obtained, comprising different amounts of the fluorescent compound Disperse Red 277, as described in the Examples below.

EXAMPLE 5 - Characterisation under visible and UV light

The samples obtained as per Examples 1-4 are listed in the following Table 1.

Table 1

| Sample | Aqueous polymer dispersion | Fluorescent compound | % by weight fluorescent compound |
|---|---|---|---|
| LSC101 | ®Polidisp 7788 | Basic Yellow 40 | 0.3 |
| LSC102 | ®Polidisp 7788 | Basic Yellow 40 | 0.6 |
| LSC103 | ®Polidisp 7788 | Basic Yellow 40 | 1 |
| LSC104 | ®Polidisp 7788 | Basic Yellow 40 | 1.5 |

(continued)

| Sample | Aqueous polymer dispersion | Fluorescent compound | % by weight fluorescent compound |
|---|---|---|---|
| LSC201 | ®Polidisp 7602 | Basic Yellow 40 | 0.5 |
| LSC202 | ®Polidisp 7602 | Basic Yellow 40 | 1 |
| LSC203 | ®Polidisp 7602 | Basic Yellow 40 | 1.5 |
| LSC204 | ®Polidisp 7602 | Basic Yellow 40 | 2 |
| LSC301 | ®Tecfin 40 | Basic Yellow 40 | 0.3 |
| LSC302 | ®Tecfin 40 | Basic Yellow 40 | 0.5 |
| LSC303 | ®Tecfin 40 | Basic Yellow 40 | 0.6 |
| LSC304 | ®Tecfin 40 | Basic Yellow 40 | 1 |
| LSC305 | ®Tecfin 40 | Basic Yellow 40 | 2 |
| LSC401 | ®Polidisp 7602 | Disperse Red 277 | 0.5 |
| LSC402 | ®Polidisp 7602 | Disperse Red 277 | 1 |
| LSC403 | ®Polidisp 7602 | Disperse Red 277 | 1.5 |
| LSC404 | ®Polidisp 7602 | Disperse Red 277 | 2 |

Said samples were observed both under visible light and under UV light at 366 nm with the aim of evaluating the homogeneity of the polymeric film deposited on the glass substrate, the uniformity of distribution of the fluorescent compound within said polymeric film and the effective ability to concentrate the incident luminous radiation on the substrate, that is, the lateral surfaces of the substrate.

These samples were also compared with a sample prepared with the same glass substrate of high optical purity (Edmund Optics Ltd BOROFLOAT window 50x50 TS), but without the fluorescent polymeric film coating in order to evaluate the differences as regards the emission of fluorescence and the concentration of luminous radiation on the lateral surfaces of the substrate.

By way of example, Figures 3 and 4 show a comparison of the optical properties (under irradiation with visible light and with UV light at 366 nm, respectively) of the sample LSC103 obtained by deposition of a fluorescent polymeric film on a glass substrate of an aqueous polymer dispersion comprising ®Polidisp 7788 and 1% by weight of Basic Yellow 40 as described in Example 1, and a sample consisting of an analogous glass substrate but without the deposition of said fluorescent polymeric film. As may be observed from Figure 3, the LSC sample according to the present invention is not opaque and has a good residual transparency. In particular, under irradiation both with visible light (Figure 3) and with UV light at 366 nm (Figure 4) it is possible to observe that the amount of luminous radiation emitted is concentrated on the lateral surfaces of the substrate when it is coated with the fluorescent polymeric film as described in Example 1.

Example 6 - Study on the optical efficiency of a device comprising LSC

The LSC samples obtained as per Examples 1-4 were subjected to subsequent tests adapted to measure their performance in terms of optical efficiency.

The tests were developed by the Applicant ("Luminescent Solar Concentrators Based on Renewable Polyester Matrices", Chem. Asian J. 2019, 14, 877-883) and provide for the use of a solar simulator as a light source and of a photovoltaic (PV) cell, installed on the edges of said samples and connected to a PC by means of an Arduino device.

By way of example, Figures 5 and 6 show the gain in terms of current generated and power obtained by connecting, respectively, the samples LSC103 (Example 1) and LSC305 (Example 3) to the voltaic cell.

Similar curves were also obtained for the other samples produced as per Examples 1-4. For all samples, both current and power curves were obtained and they show a significant increase following the connection of the luminescent solar concentrator LSC with the photovoltaic cell. In order to quantify the performance of the LSCs prepared, a calculation was made of the optical efficiency η%, which is derived from the ratio between the concentration factor (C) and the geometric factor (G) according to the equations (1) and (2):

$$(1)\ C = I_{LSC+PV}/I_{PV}$$

$$(2)\ (\text{area base surface})/(\text{area lateral surface})$$

wherein the concentration factor (C) is given by the ratio between the parameters $I_{LSC+PV}$ and $I_{PV}$, which represent, respectively, the short circuit intensities of the device in the presence and in the absence of the LSC, as obtained on the basis of the maximum recorded current values, whereas the geometric factor (G) is given by the ratio between the base surface and the lateral surface of the substrate, which, in the case of the samples obtained as per Examples 1-4 is equal to 16.67.

The following Table 2 shows the optical performance of the LSCs prepared as per Examples 1-4

Table 2

| Sample | Aqueous polymer dispersion | Fluorescent compound | % by weight of fluorescent compound | C | η% |
|---|---|---|---|---|---|
| LSC101 | ®Polidisp 7788 | Basic Yellow 40 | 0.3 | 1.36±0.01 | 8.2±0.1 |
| LSC102 | ®Polidisp 7788 | Basic Yellow 40 | 0.6 | 1.41±0.01 | 8.5±0.2 |
| LSC103 | ®Polidisp 7788 | Basic Yellow 40 | 1 | 1.44±0.01 | 8.6±0.1 |
| LSC104 | ®Polidisp 7788 | Basic Yellow 40 | 1.5 | 1.20±0.01 | 7.2±0.2 |
| LSC201 | ®Polidisp 7602 | Basic Yellow 40 | 0.5 | 1.40±0.01 | 8.5±0.1 |
| LSC202 | ®Polidisp 7602 | Basic Yellow 40 | 1 | 1.36±0.01 | 8.2±0.2 |
| LSC203 | ®Polidisp 7602 | Basic Yellow 40 | 1.5 | 1.57±0.01 | 9.5±0.2 |
| LSC204 | ®Polidisp 7602 | Basic Yellow 40 | 2 | 1.31±0.01 | 7.9±0.2 |
| LSC301 | ®Tecfin 40 | Basic Yellow 40 | 0.3 | 1.18±0.01 | 7.1±0. 1 |
| LSC302 | ®Tecfin 40 | Basic Yellow 40 | 0.5 | 1.25±0.01 | 7.5±0.1 |
| LSC303 | ®Tecfin 40 | Basic Yellow 40 | 0.6 | 1.26±0.01 | 7.6±0.1 |
| LSC304 | ®Tecfin 40 | Basic Yellow 40 | 1 | 1.29±0.01 | 7.8±0.1 |
| LSC305 | ®Tecfin 40 | Basic Yellow 40 | 2 | 1.46±0.01 | 8.7±0.2 |
| LSC401 | ®Polidisp 7602 | Disperse Red 277 | 0.5 | 1.20±0.01 | 7.2±0.1 |
| LSC402 | ®Polidisp 7602 | Disperse Red 277 | 1 | 1.26±0.01 | 7.6±0.2 |
| LSC403 | ®Polidisp 7602 | Disperse Red 277 | 1.5 | 1.37±0.01 | 8.3±0.3 |
| LSC404 | ®Polidisp 7602 | Disperse Red 277 | 2 | 1.05±0.01 | 6.3±0.2 |

As may be inferred from the results obtained and shown in the table, between the two fluorescent water-soluble compounds, Disperse Red 277 showed slightly inferior, albeit satisfactory, performances compared to Basic Yellow 40. These performances are probably attributable to a worse dispersion (in terms of uniformity and homogeneity) of the fluorescent compound within the polymeric film formed on the substrate once the water evaporated, demonstrating the fact that the effective dispersion of the fluorescent compound is a decisive characteristic for ensuring the high performance of the LSC.

In any case, all of the samples show high performances in terms of optical efficiency (comprised between 6.3±0.2% and 9.5±0.2%), confirming the effectiveness of the invention for the different formulations.

## Claims

1. A luminescent solar concentrator (LSC) comprising an aqueous polymer dispersion comprising at least one fluorescent compound dispersed in said aqueous polymer dispersion, said at least one fluorescent compound being water soluble.

2. The luminescent solar concentrator according to claim 1, wherein said at least one fluorescent compound is present in an amount comprised between 0.2 and 10% by weight, preferably between 0.5 and 7% by weight, more preferably between 1 and 5%, even more preferably between 2 and 5%, still more preferably between 0.2 and 2% by weight, relative to the total weight of the luminescent solar concentrator.

3. The luminescent solar concentrator according to claim 1 or 2, wherein said at least one fluorescent compound is a coumarin derivative selected from 2-[7-(diethylamino)-2-oxo-2H-1-benzopyran-3-yl]-1,3-dimethyl-1H-benzimidazolium chloride (Basic Yellow 40, CAS no. 29556-33-0), Acid Yellow 250 (CAS no. 70267-73-1), Disperse Yellow 184 (CAS no. 67297-27-2), a compound having the formula (I) (Disperse Red 277, CAS no. 70294-19-8),

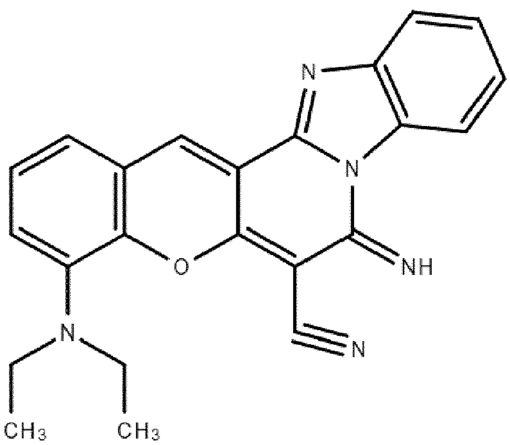

(I)

and a combination thereof.

4. The luminescent solar concentrator according to any one of the preceding claims, wherein said aqueous polymer dispersion comprises at least one polymer selected in the group consisting of an acrylic-styrene acid ester (co)polymer, acrylic-methacrylic acid ester (co)polymer, a polyester-based aliphatic polyurethane, a polyether-based aliphatic polyurethane and a combination thereof.

5. The luminescent solar concentrator according to claim 4, wherein said aqueous polymer dispersion comprises said at least one polymer in an amount comprised between 20 and 60% by weight, preferably between 30 and 55% by weight, relative to the total weight of the aqueous polymer dispersion.

6. The luminescent solar concentrator comprising a substrate partially or entirely coated with a polymeric film obtained from the aqueous polymer dispersion according to any one of the preceding claims, said polymeric film comprising said at least one fluorescent compound uniformly distributed therein, said film preferably having a homogeneous thickness comprised between 25 and 300 μm, more preferably between 40 and 100 μm, said film preferably being a transparent or translucent film for solar radiation.

7. The luminescent solar concentrator according to claim 6, wherein said at least one fluorescent compound is present in said polymeric film in an amount comprised between 0.5 and 7%, preferably between 0.2 and 2%, relative to the total weight of the polymeric film.

8. The luminescent solar concentrator according to claim 6 or 7, wherein said substrate comprises at least one base surface and at least one lateral surface, said at least one lateral surface having a surface area that is smaller than the surface area of the at least one base surface, said substrate preferably being made of a transparent or translucent material for solar radiation, said transparent or translucent material preferably being selected from vitreous and/or polymeric materials, more preferably selected in group consisting of: glass, polymethylmethacrylate, polycarbonate, copolymers of cyclic olefins and epoxy resins.

**9.** A device for exploiting solar energy comprising at least one luminescent solar concentrator according to any one of claims 6 to 8 and at least one cell selected from photovoltaic or photoelectrochemical cells, said at least one cell being in connection with the substrate and being positioned on the at least one lateral surface of said substrate.

**10.** The device for exploiting solar energy according to claim 9, **characterised in that** it has a value of optical efficiency η% comprised between 5 and 10%, preferably between 6 and 10%.

**11.** A use of the device according to claim 9 or 10 as an element for the construction and/or decoration of an architectural structure, said element being preferably selected from a window, a French door, a display window, a terrace, a balcony, a parapet, a motorway sound-absorbing panel and a vehicle roof; said architectural structure being preferably selected from a building, a greenhouse and an infrastructure.

Fig. 1

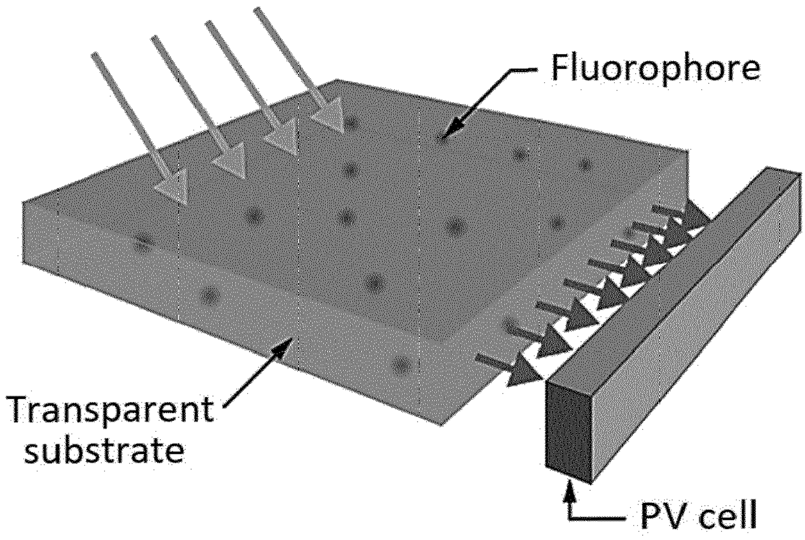


Fig.2

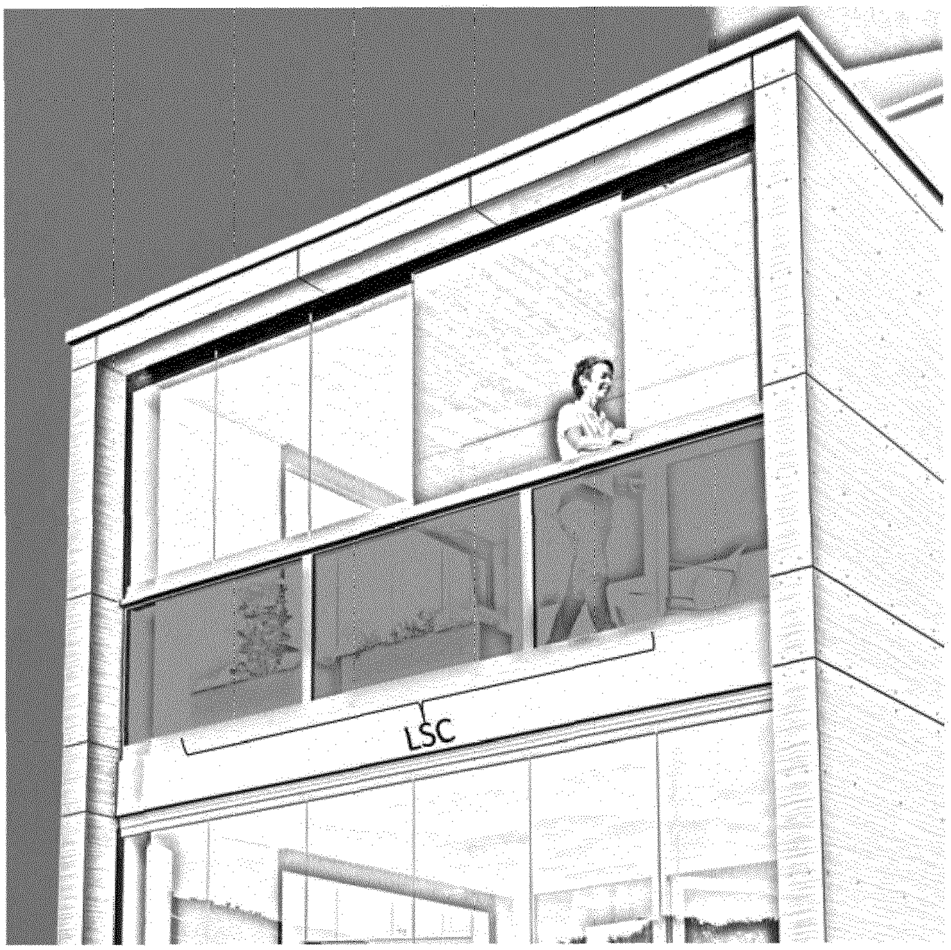

Fig. 3

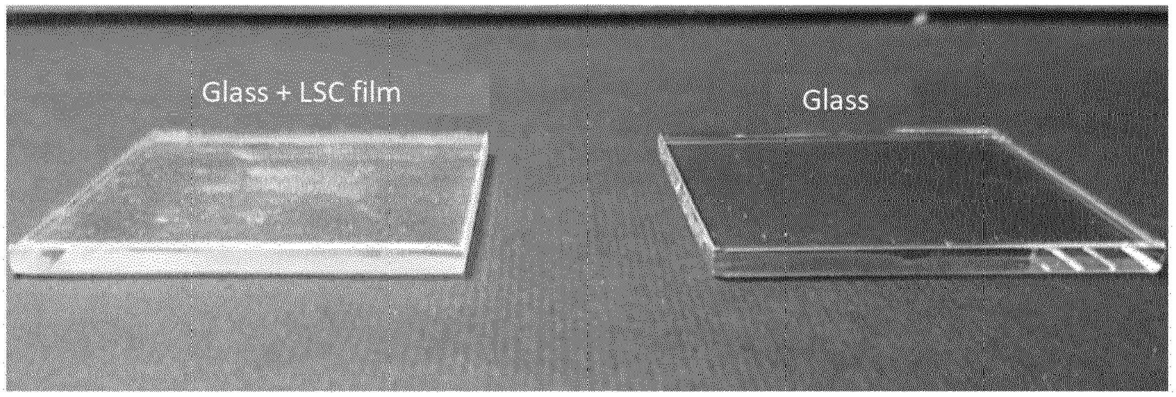


Fig. 4

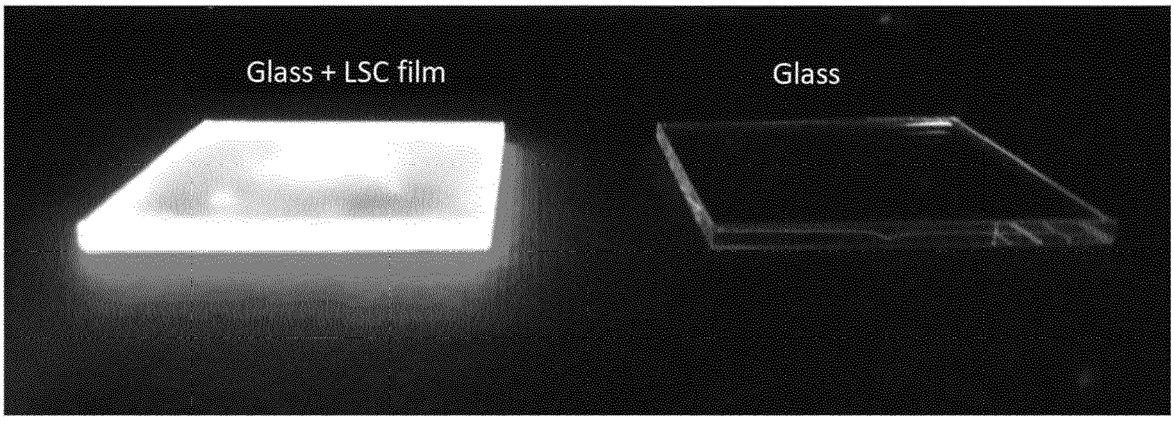

Fig. 5

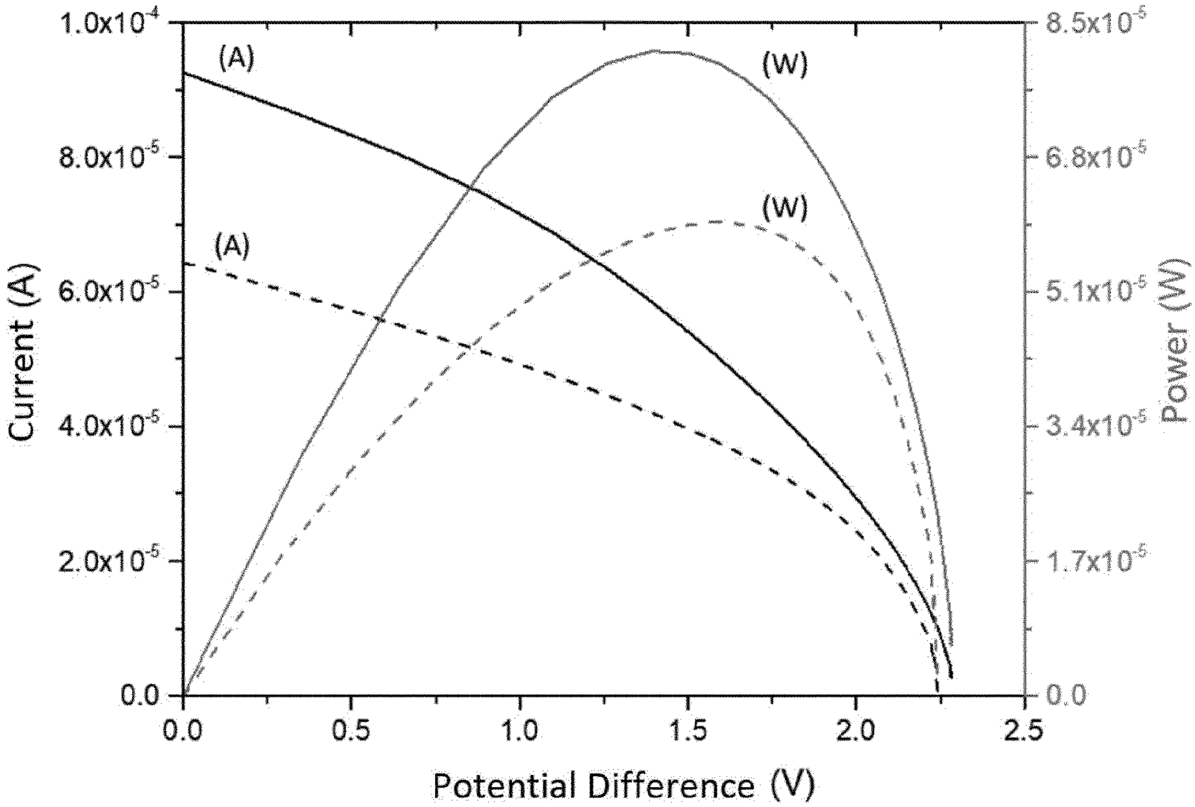
1.0x10-4
8.0x10-5
6.0x10-5
4.0x10-5
2.0x10-5
0.0
Current (A)
(A)
(A)
(W)
(W)
8.5x10-5
6.8x10-5
5.1x10-5
3.4x10-5
1.7x10-5
0.0
Power (W)
0.0
0.5
1.0
1.5
2.0
2.5
Potential Difference (V)

Fig. 6

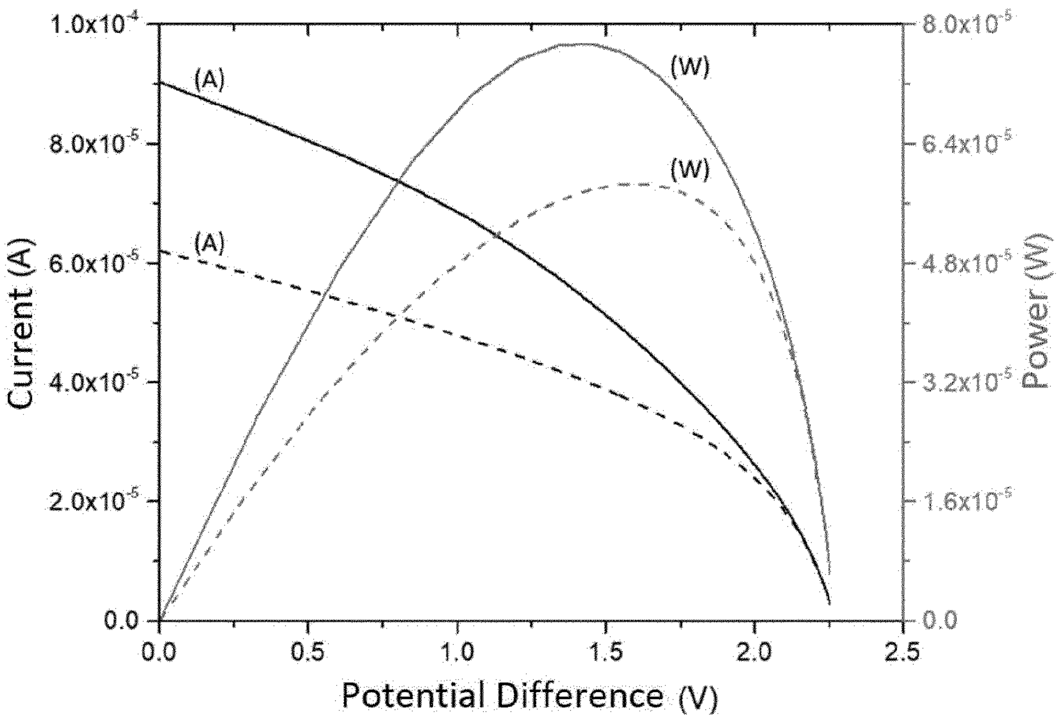
1.0x10-4
8.0x10-5
6.0x10-5
4.0x10-5
2.0x10-5
0.0
Current (A)
(A)
(A)
(W)
(W)
8.0x10-5
6.4x10-5
4.8x10-5
3.2x10-5
1.6x10-5
0.0
Power (W)
0.0
0.5
1.0
1.5
2.0
2.5
Potential Difference (V)

Europäisches Patentamt
European Patent Office
Office européen des brevets

# EUROPEAN SEARCH REPORT

Application Number
EP 20 20 9691

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X<br>A | EP 2 485 271 A1 (HITACHI CHEMICAL CO LTD [JP]) 8 August 2012 (2012-08-08)<br>* paragraph [0112] - paragraph [0139] *<br>----- | 1,9,11<br>2-8,10 | INV.<br>H01L31/055 |
| A | YI ZHANG ET AL.: "Enhanced efficiency of the luminescent solar concentratorfabricated with an aqueous layer",<br>CHINESE OPTICS LETTERS,<br>vol. 12, no. 7, 073501,<br>1 January 2014 (2014-01-01), pages 1-4, XP002799837,<br>* page 1 - page 3 *<br>----- | 1-11 | |
| A | YIGE WANG, PENG LI, SHUFANG WANG, HUANRONG LI: "Recent progress in luminescent materials based on lanthanidecomplexes intercalated synthetic clays",<br>JOURNAL OF RARE EARTHS,<br>vol. 37, 11 December 2018 (2018-12-11), pages 451-467, XP002799836,<br>* page 451 - page 465 *<br>----- | 1-11 | TECHNICAL FIELDS SEARCHED (IPC)<br>H01L |

The present search report has been drawn up for all claims

1

| Place of search | Date of completion of the search | Examiner |
|---|---|---|
| The Hague | 22 March 2021 | Königstein, C |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

# ANNEX TO THE EUROPEAN SEARCH REPORT ON EUROPEAN PATENT APPLICATION NO. EP 20 20 9691

This annex lists the patent family members relating to the patent documents cited in the above-mentioned European search report.
The members are as contained in the European Patent Office EDP file on
The European Patent Office is in no way liable for these particulars which are merely given for the purpose of information.

22-03-2021

| Patent document cited in search report | Publication date | Patent family member(s) | Publication date |
|---|---|---|---|
| EP 2485271 A1 | 08-08-2012 | CN 102656705 A | 05-09-2012 |
| | | EP 2485271 A1 | 08-08-2012 |
| | | JP WO2011040391 A1 | 28-02-2013 |
| | | KR 20120053534 A | 25-05-2012 |
| | | KR 20140113736 A | 24-09-2014 |
| | | SG 10201405424Y A | 30-10-2014 |
| | | TW 201120188 A | 16-06-2011 |
| | | US 2012180865 A1 | 19-07-2012 |
| | | US 2016300971 A1 | 13-10-2016 |
| | | WO 2011040391 A1 | 07-04-2011 |

EPO FORM P0459

For more details about this annex : see Official Journal of the European Patent Office, No. 12/82

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- WO 2015159221 A


### Non-patent literature cited in the description


- **A. RENNY et al.** Luminescent Solar Concentrator Paintings: Connecting Art and Energy. *J. Chem. Educ.,* 2018, vol. 95, 1161-1166
- *CHEMICAL ABSTRACTS,* 29556-33-0
- *CHEMICAL ABSTRACTS,* 70267-73-1
- *CHEMICAL ABSTRACTS,* 67297-27-2
- *CHEMICAL ABSTRACTS,* 70294-19-8
- Luminescent Solar Concentrators Based on Renewable Polyester Matrices. *Chem. Asian J.,* 2019, vol. 14, 877-883